# EUROPEAN PATENT APPLICATION

(11) **EP 4 564 710 A1**
(43) Date of publication of application: **04.06.2025**
(21) Application number: 24205409.6
(22) Date of filing: 08.10.2024
(51) Int. Cl.: H04B 17/15, G01R 29/08, H04B 17/18

(54) **CONCURRENT ELECTROMAGNETIC FIELD (EMF) MEASUREMENT FROM MULTIPLE BASE STATIONS**

(30) Priority: 28.11.2023 US 202318520881
(71) Applicant: Viavi Solutions Inc., Chandler, AZ 85286 (US)
(72) Inventor: KU, Bon-Jin, 08512 Seoul (KR); PARK, Chang-Hyun, 08512 Seoul (KR); HONG, Seung-Gon, 08512 Seoul (KR)
(74) Representative: Murgitroyd & Company

(57) **Abstract**

Accurate and efficient EMF measurements of cellular network components such as multiple base stations are performed concurrently by selecting synchronization signal block (SSB) beams from multiple base stations toward a test device or instructing the base stations to transmit the SSB beams toward the test device. A multi-channel analog-digital converter (ADC) and RF front end combinations may be used to measure the EMF from the base stations concurrently.

## Description

### TECHNICAL FIELD

This patent application is directed to cellular network testing, and more specifically, concurrent electromagnetic field (EMF) measurement of multiple network base stations.

### BACKGROUND

A cell site, also known as a cell tower or cellular base station, includes an antenna and electronic communications equipment to support cellular mobile device communication. The antenna and equipment are typically placed in connection with a radio mast or tower, and the equipment generally connects cell site air interfaces to wireline networks, which may be comprised of fiber optic cables and coaxial cables. At a cell site, there may be a variety of signals depending on technology, e.g., 4G Long Term Evolution (LTE), 5G New Radio (NR), Dynamic Spectrum Sharing (DSS), etc. Additionally, other signals such as Citizens Broadband Radio Service (CBRS) and similar communication signals may also be present and potentially interfere with the cellular network signals.

### SUMMARY

Aspects of the invention are set out in the accompanying independent and dependent claims. Combinations of features from the dependent claims may be combined with features of the independent claims as appropriate and not merely as explicitly set out in the claims.

According to an aspect, there is provided a method to perform electromagnetic field, EMF, measurements in a cellular network, the method comprising:
identifying a plurality of base stations in a vicinity of a test device;
identifying a synchronization signal block, SSB, beam to be measured from each base station;
receiving, at the test device, signals from identified SSB beams through respective antenna modules;
digitizing the received signals through a multi-channel analog-digital converter, ADC, of the test device; and
performing the EMF measurements on the digitized signals for the identified SSB beams of respective base stations concurrently.

The method may further comprise, when identifying the SSB beam, specifying a range limited to a downlink location.

The range may be specified through SIB1 or a user input.

Identifying the SSB beam may further comprise:
identifying the SSB beam corresponding to a maximum network traffic throughput.

The method may further comprise:
selecting antenna module band pass filters, BPFs, of the test device based on center frequencies of the identified SSB beams from the plurality of base stations.

The method may further comprise:
selecting multi-channel ADC channels of the test device based on center frequencies of the identified SSB beams from the plurality of base stations.

Performing the EMF measurement may comprise:
measuring one or more of a minimum EMF, a maximum EMF, or an average EMF.

The method may further comprise comparing the EMF measurements to a radiation exposure limit.

According to another aspect, there is provided a test device to perform electromagnetic field, EMF, measurements in a cellular network, the test device comprising:
a plurality of antenna modules to receive signals from identified synchronization signal block, SSB, beams, wherein
   the SSB beams are identified to be measured for a plurality of base stations, and
   the plurality of base stations are identified in a vicinity of the test device;
a signal analyzer block comprising:
   a multi-channel analog-digital converter, ADC, to digitize the received signals; and
   a processor to perform the EMF measurements on the digitized signals for the identified SSB beams of respective base stations concurrently.

The processor may be further to:
measure isotropic EMF power from each base station over a predefined time period; and
determine accumulated isotropic EMF power for each identified SSB beam.

The processor may be further to:
display collected isotropic EMF power measurements over a predefined time period through the interactive display.

The processor may be further to:
present the EMF measurements through an interactive display of the test device; and
receive configuration input from a user.

The accumulated isotropic EMF power may be displayed on the interactive display as a minimum EMF, a maximum EMF, and an average EMF.

The processor may be further to:
identify the SSB beams corresponding to a maximum network traffic throughput.

Each antenna module may comprise an antenna, a low noise amplifier, LNA, and a band pass filter, BPF.

The processor may be further to:
select an antenna module based on a center frequency of an identified SSB beam and a center frequency of the BPF of the antenna module.

The processor may be further to:
select a channel of the multi-channel ADC based on a center frequency of an identified SSB beam.

According to a further aspect, there is provided a non-transitory computer-readable storage medium having an executable stored thereon, which when executed instructs a processor of a test device to perform electromagnetic field, EMF, measurements in a cellular network to:
identify a plurality of base stations in a vicinity of a test device;
identify a synchronization signal block, SSB, beam to be measured from each base station;
receive, at the test device, signals from the identified SSB beams through respective antenna modules;
digitize the received signals through a multi-channel analog-digital converter, ADC, of the test device; and
perform the EMF measurements for the identified SSB beams of respective base stations concurrently by measuring one or more of a minimum EMF, a maximum EMF, or an average EMF.

The executable may instruct the processor further to:
select antenna module band pass filters, BPFs, of the test device based on center frequencies of SSB beams from the plurality of base stations; and
select multi-channel ADC channels of the test device based on center frequencies of SSB beams from the plurality of base stations.

The executable may instruct the processor further to:
compare the EMF measurements to a radiation exposure limit.

### BRIEF DESCRIPTION OF DRAWINGS

Features of the present disclosure are illustrated by way of example and not limited in the following Figure(s), in which like numerals indicate like elements, in which:
Figure 1 illustrates a diagram of a test device in a cellular network test environment, according to an example.
Figure 2 illustrates a block diagram of a test device such as a spectrum analyzer for performing concurrent EMF measurement of multiple cellular network base stations, according to an example.
Figure 3A illustrates instruction of a desired base station to generate maximum throughput with a user equipment and a screenshot of a test device to start EMF analysis, according to an example.
Figure 3B illustrates selection of beams from multiple base stations during EMF measurement, according to an example.
Figure 4 illustrates a flow chart of a method for concurrent EMF measurement of multiple network base stations, according to an example.
Figure 5 illustrates a block diagram of the test device, according to an example.

### DETAILED DESCRIPTION

For simplicity and illustrative purposes, the present disclosure is described by referring mainly to examples and embodiments thereof. In the following description, numerous specific details are set forth in order to provide a thorough understanding of the present disclosure. It will be readily apparent, however, that the present disclosure may be practiced without limitation to these specific details.

In other instances, some methods and structures readily understood by one of ordinary skill in the art have not been described in detail so as not to unnecessarily obscure the present disclosure. As used herein, the terms "a" and "an" are intended to denote at least one of a particular element, the term "includes" means includes but not limited to, the term "including" means including but not limited to, and the term "based on" means based at least in part on.

To assess the potential health risks of exposure to cellular communication (e.g., 5G) radiation, a variety of test techniques including electromagnetic field (EMF) measurement may be employed. Many countries have regulations that limit the amount of cellular communication radiation that people are allowed to be exposed to. EMF measurements and other techniques may help ensure that base stations are not emitting more radiation than is allowed. Furthermore, particular problems with cellular networks, such as poor signal strength or dropped calls, may be diagnosed using EMF measurements. However, network configuration and communication parameters may play a significant role in successful use of EMF measurement results in determining health risks or other cellular network problems.

In some examples of the present disclosure, accurate and efficient EMF measurements of cellular network components such as multiple base stations may be performed concurrently by selecting synchronization signal block (SSB) beams from multiple base stations toward a test device or instructing the base stations to transmit the SSB beams toward the test device. A multi-channel analog-digital converter (ADC) and RF front end combinations may be used to measure the EMF from the base stations concurrently. In other examples, a maximum network throughput connection may be established with the desired base stations. The test device may measure signal strength of SSB beams and identify optimum SSB beam.

Some advantages and benefits of the systems and methods described herein are readily apparent. For example, EMF measurements of cellular network components such as multiple base stations concurrently may provide more accurate radiation exposure, as well as faster detection of network problem sources. Other benefits and advantages may also be apparent.

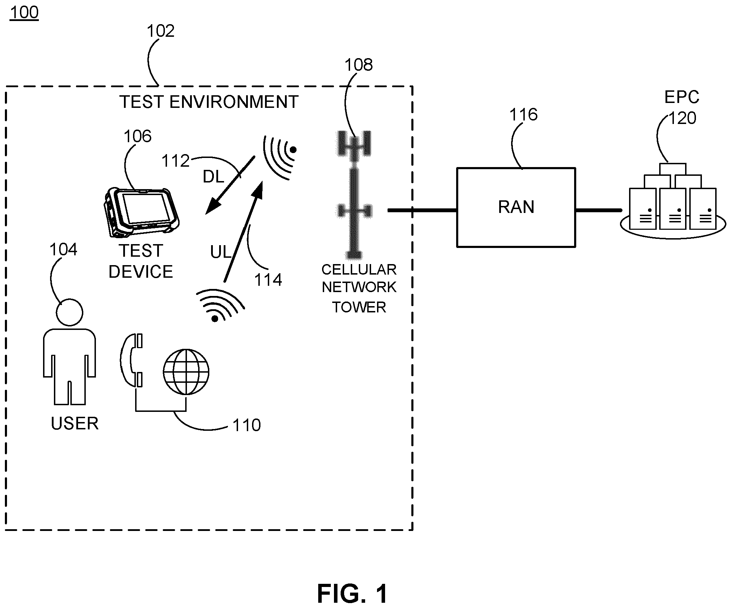

Figure 1 illustrates a diagram 100 of a test device 106 in a test environment 102, according to an example. As shown in the diagram 100, a user 104 may use user equipment (UE) 110 to communicate with other devices over the cellular network. Communication may include an uplink 114 to a cellular network tower 108 and a downlink 112 from the cellular network tower 108. A test device 106 to test and analyze signals from components at the cellular network tower 108 (e.g., a base station), as well as other signals which may come from other signal sources such as a radio tower, telecom signals, and others may be placed in close proximity with the user equipment (UE) 110. Thus, the test device 106 may measure a maximum EMF range assigned to the downlink 112 passed to user equipment (UE) 110 from the cellular network tower 108. The cellular network tower 108 may be part of a cell site and connected to backhaul via a radio access network (RAN) 116 and the backhaul may connect to Evolved Packet Core (EPC) 120.

A connection between the cellular network tower 108 and the rest of the world may be referred to as a backhaul link or simply backhaul. A backhaul may include wired, fiber optic and wireless components, such as microwave transmission equipment. In conventional 3G and 4G architectures, fronthaul is associated with a RAN 116 architecture including centralized base band units (BBUs), i.e., baseband controllers, and standalone remote radio heads (RRHs) installed at remote cell sites. These BBU and RRH functional blocks, as well as the equipment that performs these functions, are located further away from each other than in prior mobile backhaul models. In some instances, the RRH and BBU are at the same location. In other instances, the RRH is located at the cell site, whereas the BBU is located in a centralized and protected location where it serves multiple RRHs. The optical links that interconnect the BBU and the multiple RRHs are referred to as fronthaul. The fronthaul includes interfaces between the RRH and the BBU. The backhaul includes interfaces between the BBU and the EPC 120.

In an example, the test environment 102 may include the cell site, which includes the cellular network tower 108 or cellular base station having antennas and electronic communications equipment to support cellular mobile device communication. The antennas and equipment are typically placed in connection with a radio mast or tower, and the equipment generally connects cell site air interfaces to wireline networks, which may include fiber optic cables and coaxial cables. Typically, the cell site may be connected to backhaul via the RAN 116 and the backhaul may connect to the EPC 120.

The RAN is the part of a mobile network that connects end-user devices, like smartphones, to the cloud. This is achieved by sending information via radio waves from end-user devices to a RAN's transceivers, and finally from the transceivers to the core network which connects to the global internet. Diagram 100 shows the test device 106 performing signal analysis. In an example, the user 104, such as a cellular service provider technician, may use the test device 106 to perform signal analysis for discovered carrier frequency and technology as well as discovered channels of selected technologies. Furthermore, interference hunting and beam centric electromagnetic field (EMF) testing on a selected carrier may be performed with the test device 106. In an example use case, the testing may be performed when the cell site is being installed, such as to ensure proper operation of the cell site with user devices, such as smartphones or other end user cellular devices. In another example use case, after installation, customers of the cellular service provider may be having technical issues, and the user 104 may use the test device 106 to check for signal interference from the other signal sources or other potential causes of the technical issues so the technical issues can be resolved.

As discussed herein, the test device 106 may be operable to perform an EMF analysis of multiple base stations, which in some examples may be configured to maximum network throughput. Technologies employed by the network may include, but are not limited to, 4G LTE, 5G NR, 6G, and DSS. Additional examples of the technologies may include LTE- FDD, LTE-TDD, NR, DSS-FDD, DSS-TDD where FDD is frequency division duplex and TDD is time division duplex.

Accurate and efficient testing and analysis of EMF measurements of cellular network components such as multiple base stations may be performed by selecting synchronization signal block (SSB) beams from multiple base stations directed to a user equipment (UE), and a test device may be co-located with the UE allowing the test device to measure EMF from the base stations concurrently using a multi-channel analog-digital converter (ADC).

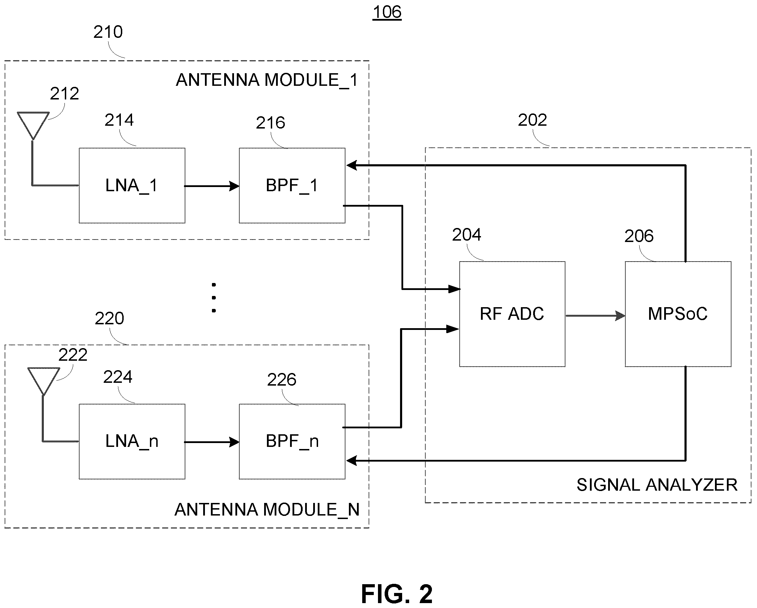

Figure 2 illustrates a block diagram of a test device such as a spectrum analyzer for performing concurrent EMF measurement of multiple cellular network base stations, according to an example. Example sub-blocks of the test device 106 may include, but are not limited to, antenna modules 210, 220, etc., and signal analyzer block 202. Each of the antenna modules may include an antenna (antenna 212 in the antenna module 210, antenna 222 in the antenna module 222, etc.), a low noise amplifier (LNA) (LNA_1 214 in the antenna module 210, LNA_n 224 in the antenna module 222, etc.), and a band pass filter (BPF) (BPF_1 216 in the antenna module 210, BPF_n 226 in the antenna module 222, etc.). The signal analyzer block 202 may include a multi-channel RF ADC 204 and a processor such as multiprocessor system on a chip (MPSoC) 206.

In an operation, input signals (e.g., SSB beams from the base stations) may be received the test device 106 through individual antennas (the antenna 212 through the antenna 222) and pre-processed by respective front end circuitry (e.g., LNAs and BPFs of the antenna modules 210 through 220). The front end circuitry may also include, among other circuits and subsystems, an attenuator and/or a mixer. The pre-processed RF signals may be down-converted at a mixer (not shown), and the down-converted signals provided to respective channels of multi-channel RF ADC 204 of the signal analyzer block 202. In some examples, each antenna module may have its own mixer. In other examples, the pre-processed RF signals from the antenna modules may be converted at a single mixer (e.g., time-multiplexed) that is part of the signal analyzer block 202.

The antennas 212, 222, and others may be omnidirectional (e.g., in a scenario where signals may be from different service providers at different frequencies and locations of the base stations may be known) or directional (providing more accurate measurement results). The antenna module BPFs and/or ADC channels may be selected based on a center frequency selection by a technician or the processor.

Digitized signals from the multi-channel RF ADC 204 may be provided to the processor (MPSoC) 206 for digital processing, analysis, and reporting. The processor (MPSoC) 206 may manage one or more components of the test device 106 such as the multi-channel RF ADC 204, a field programmable gate array (FPGA) (not shown), clocks, and other operational circuits and devices (also referred to as operational subsystems).

In some examples, channels of the multi-channel RF ADC 204 may be dedicated to respective antenna module outputs. In other examples, the channels may be selected dynamically, for example, by the processor (MPSoC) 206 or based on availability. The operational circuits and devices may perform analytical operations such as displaying the signals, fast Fourier transforms (FFTs), storing the signals and/or analysis results, and similar operations. Thus, the operational circuits and devices may include an analysis subsystem, a display subsystem, an FFT subsystem, a storage subsystem, and comparable subsystems and circuits. As mentioned herein, the test device 106 may be a spectrum analyzer (for example, a portable spectrum analyzer to be used in the field) and may include additional circuitry and subsystems such as a voltage-controlled oscillator (VCO) for the mixer(s), additional filters, mixers, oscillators, a frequency synthesizer, and so on. Thus, the analog input signal(s) may be processed by any number of analog processing circuitry and the digital signals converted by the multi-channel RF ADC 204 may be processed by any number of digital processing circuitry.

In some example scenarios, the test device may be at a cell edge of overlapping cells and receive signals from two or more base stations with comparable signal levels from the same service provider. In such scenarios, the center frequency of the beams may be same. In other scenarios, the beams may be from different service providers, thus as different frequencies. In the latter scenarios, a technician may enter the center frequencies for the different beams.

While examples are described herein for EMF measurements of cellular network components such as multiple base stations concurrently by selecting synchronization signal block (SSB) beams from multiple base stations, 5G, 4G, 3G, etc. related transmission parameters may also be measured using the same principles.

It should be appreciated that a test device to perform EMF measurements from multiple base stations may be a spectrum analyzer and implemented with any number components, where certain functionality may be distributed among various components and sub-systems or performed by additional components or sub-systems. Furthermore, the test device may be any RF test device including, but not limited to, a spectrum analyzer, a cellular system monitoring device, an RF power analyzer, etc.

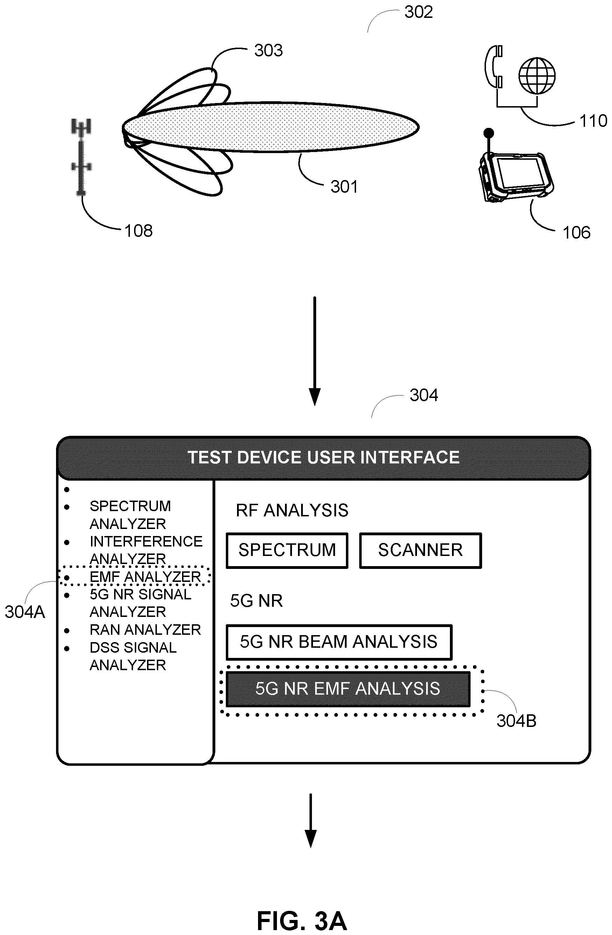

Figure 3A illustrates instruction of a desired base station to generate maximum throughput with a user equipment and a screenshot of a test device to start EMF analysis, according to an example.

Diagram 302 in Figure 3A shows selection of the optimum beam 301 (among multiple beams 303) from the network cellular tower 108 (base station) during synchronization with UE 110 so that test device 106 in vicinity of the UE 110 can receive maximum EMF from the base station. Screenshot 304 in Figure 3A is an example test device user interface showing test device setup. The test device 106 may be capable of performing multiple functions such as spectrum analysis, interference analysis, EMF analysis, 5G NR signal analysis, etc. Among available functions, EMF analysis 304A may be selected by a user and options associated with EMF analysis may be displayed. Among the displayed options, 5G NR traffic analysis 304B may be selected to create maximum network throughput from the base station. The UE 110 may request a particular beam, bandwidth part (BWP), and resource block.

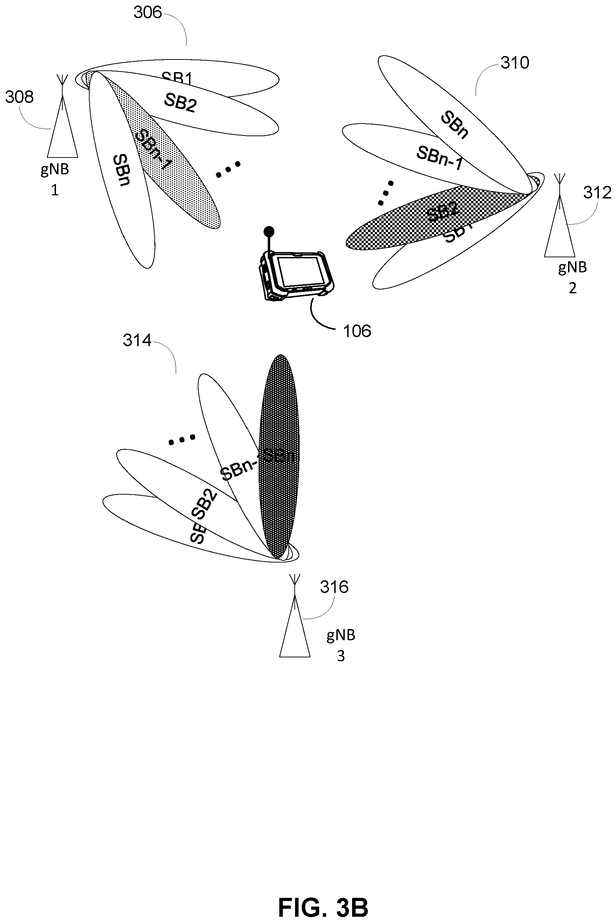

Figure 3B illustrates selection of beams from multiple base stations during EMF measurement, according to an example. In the example configuration of Figure 3B, three base stations 308, 312, 316 are shown in a vicinity of the test device 106. Each base station may transmit a plurality of beams such as beams 306 from the base station 308, beams 310 from the base station 312, and beams 314 from the base station 316.

In some examples, a base station (e.g., the base station 312) may transmit one beam among the plurality of its beams toward the test device 106. Thus, that beam may be selected. In other examples, more than one beam from the base station may be transmitted toward the test device. In that scenario, the beam with higher network traffic throughput may be selected. The test device 106 may request transmission of a selected beam from the respective base stations directly (e.g., when the test device is configured to be able to communicate with the cellular network like a UE) or through a UE near the test device. In other cases, the test device may perform the EMF measurements when all three base stations are transmitting the selected SSB beams (e.g., during beam sweeping).

The interactions begin with beam sweeping by the base station with primary synchronization signal (PSS), secondary synchronization signal (SSS), and primary broadcast channel (PBCH). The beam sweeping also provides minimum system information over the PBCH. A UE responds to the base station with random access channel (RACH) request. In the initial cell-wide operation, the UE may find the optimum beam from the base station during synchronization and decode system information block (SIB) on that beam. The UE may notify the network (gNB) of the optimum synchronization signal block (SSB) by using the corresponding PRACH resource.

In a UE-specific operation, the base station may transmit a UE-specific physical downlink shared channel (PDSCH) beam, RACH response, system information, and radio resource control (RRC) connection setup information. The network (gNB) may also request beam / CSI reporting with data transmission on beamformed PDSCH. The UE may respond with beam / CSI report, which may be followed by primary synchronization signal (PSS), secondary synchronization signal (SSS), and primary broadcast channel (PBCH) beam switch (handover).

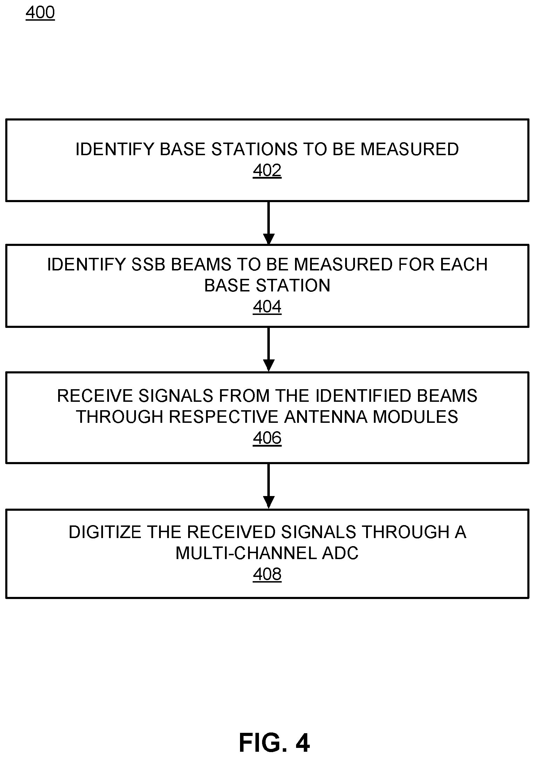

Figure 4 illustrates a flow chart of a method for concurrent EMF measurement of multiple network base stations, according to an example. The method 400 is provided by way of example, as there may be a variety of ways to carry out the method described herein. Although the method 400 is primarily described as being performed by the test device 106 of Figure 1, the method 400 may be executed or otherwise performed by one or more processing components of another system or a combination of systems. Each block shown in Figure 4 may further represent one or more processes, methods, or subroutines, and one or more of the blocks (e.g., the selection process) may include machine readable instructions stored on a non-transitory computer readable medium and executed by a processor or other type of processing circuit to perform one or more operations described herein.

At block 402, the test device 106 may identify base stations within a vicinity of the test device whose SSB beams may be measured for EMF. In some example scenarios, the test device may be at a cell edge of overlapping cells and receive signals from two or more base stations with comparable signal levels from the same service provider. In such scenarios, the center frequency of the beams may be same. In other scenarios, the beams may be from different service providers, thus as different frequencies.

At block 404, SSB beams to be measured for each base station may be identified. Each base station may transmit a plurality of beams. The test device may select a beam that is directed at it or, in case of two or more closely aligned beams, a beam with maximum network traffic throughput.

At block 406, the test device may receive signals from the identified beams through its multiple antenna modules. In case of different frequencies, the BPFs of the antenna modules may be set to the center frequencies of the selected beams. In case of same frequency, the antenna modules may utilize spatially separated antennas to receive the different signals.

At block 408, the signals received through the antenna modules may be digitized by a multi-channel ADC and analyzed to determine EMF levels (e.g., compare them to regulatory limits).

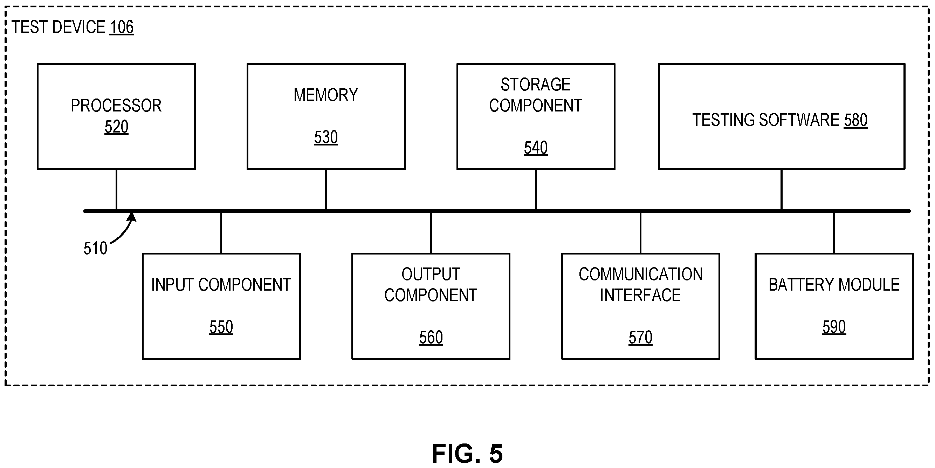

Figure 5 illustrates a block diagram of the test device 106, according to an example. As shown in block diagram, the test device 106 may include the components shown in Figure 5. The test device 106 may include a bus 510, a processor 520, a memory 630, a storage component 540, an input component 550, an output component 560, a communication interface 570, and battery module 590.

Bus 510 includes a component that permits communication among the components of test device 106. Processor 520 may be implemented in hardware, firmware, or a combination of hardware and software. Processor 520 may include one or more of a central processing unit (CPU), a graphics processing unit (GPU), an accelerated processing unit (APU), a microprocessor, a microcontroller, a digital signal processor (DSP), a field-programmable gate array (FPGA), an application-specific integrated circuit (ASIC), or another type of processing component. In some examples, processor 520 may include one or more processors capable of being programmed to perform a function. Memory 530 may include one or more memories such as a random access memory (RAM), a read only memory (ROM), and/or another type of dynamic or static storage device (e.g., a flash memory, a magnetic memory, and/or an optical memory) that store information and/or instructions for use by processor 520.

Storage component 540 stores information and/or software related to the operation and use of test device 106. For example, storage component 540 may include a hard disk (e.g., a magnetic disk, solid state disk, etc.) and/or another type of non-transitory computer-readable medium. Test device 106 may also include testing software 580 executed by the processor 520 to perform various functional tests.

The input component 550 may include a component that permits the test device 106 to receive information, such as via user input (e.g., a touch screen display, a keyboard, a keypad, a mouse, a button, a switch, and/or a microphone). Additionally, or alternatively, input component 550 may include a sensor for sensing information (e.g., a GPS component, an accelerometer, a gyroscope, and/or an actuator). Output component 560 includes a component that provides output information from the test device 106 (e.g., a display, a speaker, a user interface, and/or one or more light-emitting diodes (LEDs)). Output component 560 may include a display providing a GUI. Input component 550 and output component 560 may be combined into a single component, such as a touch responsive display, also known as an interactive display or a touchscreen.

Communication interface 570 may include a transceiver-like component (e.g., a transceiver and/or a separate receiver and transmitter) that enables test device 106 to communicate with other devices, such as via a wired connection, a wireless connection, or a combination of wired and wireless connections. Communication interface 570 may permit the test device 106 to receive information from another device and/or provide information to another device. For example, communication interface 570 may include an Ethernet interface, an optical interface, a coaxial interface, an infrared interface, an RF interface, a universal serial bus (USB) interface, a Wi-Fi interface, a cellular network interface, or the like.

Battery module 590 is connected along bus 510 to supply power to processor 520, memory 530, and internal components of the test device 106. Battery module 590 may supply power during field measurements by the test device 106. Battery module 590 may permit the test device 106 to be a portable.

The test device 106 may perform one or more processes described herein. The test device 106 may perform these processes by processor 520 executing software instructions stored by a non-transitory computer-readable medium, such as memory 530 and/or storage component 540. A computer- readable medium is defined herein as a non-transitory memory device. A memory device includes memory space within a single physical storage device or memory space spread across multiple physical storage devices.

Software instructions may be read into memory 530 and/or storage component 540 from another computer-readable medium or from another device via communication interface 570. When executed, software instructions stored in memory 530 and/or storage component 540 may instruct processor 520 to perform one or more processes described herein. Additionally, or alternatively, hardwired circuitry may be used in place of or in combination with software instructions to perform one or more processes described herein. Thus, implementations described herein are not limited to any specific combination of hardware circuitry and software.

The test device 106 may include components other than shown. For example, the test device 106 may include a spectrum analyzer and power meter for performing tests described above. The number and arrangement of components shown in Figure 5 are provided as an example. In practice, the test device 106 may include additional components, fewer components, different components, or differently arranged components than those shown in Figure 5. Additionally, or alternatively, a set of components (e.g., one or more components) of the test device 106 may perform one or more functions described as being performed by another set of components of the test device 106.

While examples described herein are directed to configurations as shown, it should be appreciated that any of the components described or mentioned herein may be altered, changed, replaced, or modified, in size, shape, and numbers, or material, depending on application or use case, and adjusted for desired resolution or optimal measurement results.

It should be appreciated that the apparatuses, systems, and methods described herein may minimize and/or reduce EMF measurement errors and inaccuracies, and thereby facilitate more reliable and accurate measurements, specifically for concurrent EMF measurement from multiple base stations. It should also be appreciated that the apparatuses, systems, and methods, as described herein, may also include, or communicate with other components not shown. For example, these may include external processors, counters, analyzers, computing devices, and other measuring devices or systems. This may also include middleware (not shown) as well. The middleware may include software hosted by one or more servers or devices. Furthermore, it should be appreciated that some of the middleware or servers may or may not be needed to achieve functionality. Other types of servers, middleware, systems, platforms, and applications not shown may also be provided at the backend to facilitate the features and functionalities of the testing and measurement system.

Moreover, single components may be provided as multiple components, and vice versa, to perform the functions and features described herein. It should be appreciated that the components of the system described herein may operate in partial or full capacity, or it may be removed entirely. It should also be appreciated that analytics and processing techniques described herein with respect to the optical measurements, for example, may also be performed partially or in full by other various components of the overall system.

It should be appreciated that data stores may also be provided to the apparatuses, systems, and methods described herein, and may include volatile and/or nonvolatile data storage that may store data and software or firmware including machine-readable instructions. The software or firmware may include subroutines or applications that perform the functions of the measurement system and/or run one or more applications that utilize data from the measurement or other communicatively coupled system.

The various components, circuits, elements, components, and interfaces, may be any number of mechanical, electrical, hardware, network, or software components, circuits, elements, and interfaces that serves to facilitate communication, exchange, and analysis data between any number of or combination of equipment, protocol layers, or applications. For example, the components described herein may each include a network or communication interface to communicate with other servers, devices, components or network elements via a network or other communication protocol.

What has been described and illustrated herein are examples of the disclosure along with some variations. The terms, descriptions, and figures used herein are set forth by way of illustration only and are not meant as limitations.

## Claims

1. A method to perform electromagnetic field, EMF, measurements in a cellular network, the method comprising:
identifying a plurality of base stations in a vicinity of a test device;
identifying a synchronization signal block, SSB, beam to be measured from each base station;
receiving, at the test device, signals from identified SSB beams through respective antenna modules;
digitizing the received signals through a multi-channel analog-digital converter, ADC, of the test device; and
performing the EMF measurements on the digitized signals for the identified SSB beams of respective base stations concurrently.

2. The method of claim 1, further comprising:
when identifying the SSB beam, specifying a range limited to a downlink location,
and optionally wherein:
the range is specified through SIB1 or a user input.

3. The method of claim 1 or claim 2, wherein identifying the SSB beam further comprises:
identifying the SSB beam corresponding to a maximum network traffic throughput.

4. The method of any preceding claim, further comprising:
selecting antenna module band pass filters, BPFs, of the test device based on center frequencies of the identified SSB beams from the plurality of base stations.

5. The method of any preceding claim, further comprising:
selecting multi-channel ADC channels of the test device based on center frequencies of the identified SSB beams from the plurality of base stations.

6. The method of any preceding claim, wherein performing the EMF measurements comprises:
measuring one or more of a minimum EMF, a maximum EMF, or an average EMF,
and/or wherein the method further comprises comparing the EMF measurements to a radiation exposure limit.

7. A test device to perform electromagnetic field, EMF, measurements in a cellular network, the test device comprising:
a plurality of antenna modules to receive signals from identified synchronization signal block, SSB, beams, wherein
the SSB beams are identified to be measured for a plurality of base stations, and
the plurality of base stations are identified in a vicinity of the test device;
a signal analyzer block comprising:
a multi-channel analog-digital converter, ADC, to digitize the received signals; and
a processor to perform the EMF measurements on the digitized signals for the identified SSB beams of respective base stations concurrently.

8. The test device of claim 7, wherein the processor is further to:
measure isotropic EMF power from each base station over a predefined time period; and
determine accumulated isotropic EMF power for each identified SSB beam,
and optionally wherein the processor is further to:
display collected isotropic EMF power measurements over a predefined time period through the interactive display.

9. The test device of claim 7 or claim 8, wherein the processor is further to:
present the EMF measurements through an interactive display of the test device; and
receive configuration input from a user,
and optionally wherein:
the accumulated isotropic EMF power is displayed on the interactive display as a minimum EMF, a maximum EMF, and an average EMF.

10. The test device of any of claims 7 to 9, wherein the processor is further to:
identify the SSB beams corresponding to a maximum network traffic throughput.

11. The test device of any of claims 7 to 10, wherein each antenna module comprises an antenna, a low noise amplifier, LNA, and a band pass filter, BPF,
and optionally wherein the processor is further to:
select an antenna module based on a center frequency of an identified SSB beam and a center frequency of the BPF of the antenna module.

12. The test device of claim 11, wherein the processor is further to select a channel of the multi-channel ADC based on a center frequency of an identified SSB beam.

13. A non-transitory computer-readable storage medium having an executable stored thereon, which when executed instructs a processor of a test device to perform electromagnetic field, EMF, measurements in a cellular network to:
identify a plurality of base stations in a vicinity of a test device;
identify a synchronization signal block, SSB, beam to be measured from each base station;
receive, at the test device, signals from the identified SSB beams through respective antenna modules;
digitize the received signals through a multi-channel analog-digital converter, ADC, of the test device; and
perform the EMF measurements for the identified SSB beams of respective base stations concurrently by measuring one or more of a minimum EMF, a maximum EMF, or an average EMF.

14. The non-transitory computer-readable storage medium of claim 13, wherein the executable instructs the processor further to:
select antenna module band pass filters, BPFs, of the test device based on center frequencies of SSB beams from the plurality of base stations; and
select multi-channel ADC channels of the test device based on center frequencies of SSB beams from the plurality of base stations.

15. The non-transitory computer-readable storage medium of claim 13 or claim 14, wherein the executable instructs the processor further to:
compare the EMF measurements to a radiation exposure limit.
